# EUROPEAN PATENT APPLICATION

(11) **EP 4 404 272 A1**
(43) Date of publication of application: **24.07.2024**
(21) Application number: 23202560.1
(22) Date of filing: 10.10.2023
(51) Int. Cl.: H01L 29/737, H01L 29/73, H01L 21/8226, H01L 23/34, H01L 29/08, H01L 29/417, H01L 21/331

(54) **HEATER TERMINAL CONTACTS**

(30) Priority: 20.01.2023 US 202318099366
(71) Applicant: GlobalFoundries U.S. Inc., Malta, NY 12020 (US)
(72) Inventor: RAGHUNATHAN, Uppili S., Essex Junction, VT 05452 (US); JAIN, Vibhor, Essex Junction, VT 05452 (US); NGU, Yves T., Essex Junction, VT 05452 (US); KANTAROVSKY, Johnatan A., Essex Junction, VT 05452 (US); VENTRONE, Sebastian T., Essex Junction, VT 05452 (US)
(74) Representative: Lambacher, Michael

(57) **Abstract**

The present disclosure relates to semiconductor structures and, more particularly, to heater terminal contacts, methods of operation and methods of manufacture. The structure includes: a heterojunction bipolar transistor having a collector, sub-collector region, emitter and base region; and heater terminal contacts electrically coupled to the sub-collector region.

## Description

### BACKGROUND

The present disclosure relates to semiconductor structures and, more particularly, to heater terminal contacts, methods of operation and methods of manufacture.

Transistors undergo oxide interface degradation from radiation-rich environments and aggressive biasing. As a result, devices see electrical shifts accumulating over the lifetime of a circuit and device.

More specifically, microelectronic devices can degrade when subjected to a single-event upset (SEU), also known as a single-event error (SEE). A SEU is a change of state caused by one single ionizing particle (e.g., ions, electrons, photons, etc.) striking a sensitive node in a microelectronic device, such as in microprocessors, semiconductor memories or power transistors. The state change is a result of the free charge created by ionization in or close to an important node of a logic element. The error in device output or operation caused as a result of the strike is called an SEU or a soft error.

Microelectronics can also suffer long-term effects due to a total ionizing dose (TID). For example, cumulative long term ionizing damage from TID can lead to degradation and/or device failure. For example, TID can cause devices to suffer threshold shifts, increased device leakage and power consumption, timing changes, decreased functionality, etc.

### SUMMARY

In an aspect of the disclosure, a structure comprises: a heterojunction bipolar transistor comprising a collector, sub-collector region, emitter and base region; and heater terminal contacts electrically coupled to the sub-collector region.

Additional features of the structure are set forth in dependent claims 2 to 8.

In an aspect of the disclosure, a structure comprises: a heterojunction bipolar transistor integrated with a semiconductor substrate; heater terminal contacts electrically coupled to a sub-collector region of the heterojunction bipolar transistor; a collector contact to the heterojunction bipolar transistor; a base region contact to the heterojunction bipolar transistor; and an emitter contact to the heterojunction bipolar transistor.

Additional features of the structure are set forth in dependent claims 10 to 14.

In an aspect of the disclosure, a structure comprises: a first structure comprising: a first active device; and a first set of heater terminal contacts electrically coupled to a component of the first active device; a second structure comprising: a second active device; and a second set of heater terminal contacts electrically coupled to a component of the second active device; and a redundant circuitry coupled to the first structure and the second structure, the redundant circuitry comprising: a first circuit with a first performance sensor configured to detect a change in performance of the first active device and a temperature sensor configured to detect heat generated from the first set of heater terminal contacts; and a second circuit with a performance sensor configured to detect a change in performance of the second active device and a temperature sensor configured to detect heat generated from the second set of heater terminal contacts, wherein the redundant circuitry controls a current to the first set of heater terminal contacts while maintaining electrical functionality of the second active device and non-electrical functionality to the first active device, and the redundant circuitry controls a current to the second set of heater terminal contacts while maintaining electrical functionality of the first active device and non- electrical functionality to the second active device.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows heater terminal contacts used with a transistor, amongst other features, and respective fabrication processes in accordance with aspects of the present disclosure.
FIGS. 2-9 show heater terminal contacts in different structural configurations, and respective fabrication processes, in accordance with aspects of the present disclosure.
FIG. 10 shows a representative flow of a manufacturing process for fabricating the structure shown in FIG. 1, in accordance with aspects of the present disclosure.
FIG. 11 shows a representative flow of an operation of the structures shown in FIGS. 1-9, with additional operational components in accordance with aspects of the present disclosure.

### DETAILED DESCRIPTION

The present disclosure relates to semiconductor structures and, more particularly, to heater terminal contacts, methods of operation and methods of manufacture. More specifically, the present disclosure relates to heater terminal contacts which can thermally anneal oxide interface traps that may be generated by, e.g., total ionizing dose (TID)) or single even transients (SETs), e.g., single-event upsets (SEU). Accordingly, and advantageously, the present disclosure provides a mechanism for annealing structures (e.g., insulator material) in bipolar transistors to repair damage caused by SEU and TID events.

In one exemplary embodiment, a SiGe heterojunction bipolar transistor (HBT) comprises one or more heater terminal contacts electrically coupled to a sub-collector of an NPN transistor. In embodiments, the heater terminal contacts may be additional collector contacts which electrically couple to the sub-collector region between shallow trench and/or deep trench isolation structures. The extra collector contacts, e.g., heater terminal contacts, receive a current which will generate heat to thermally anneal oxide interface traps. An airgap and/or trap-rich region below sub-collector region may be used to improve SET response. In operation, logic can detect a change in circuit performance due to radiation damage which enables the heater terminal contacts to repair or heal the degradation.

The heater terminal contacts of the present disclosure can be manufactured in a number of ways using a number of different tools. In general, though, the methodologies and tools are used to form structures with dimensions in the micrometer and nanometer scale. The methodologies, i.e., technologies, employed to manufacture the heater terminal contacts of the present disclosure have been adopted from integrated circuit (IC) technology. For example, the structures are built on wafers and are realized in films of material patterned by photolithographic processes on the top of a wafer. In particular, the fabrication of the heater terminal contacts uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

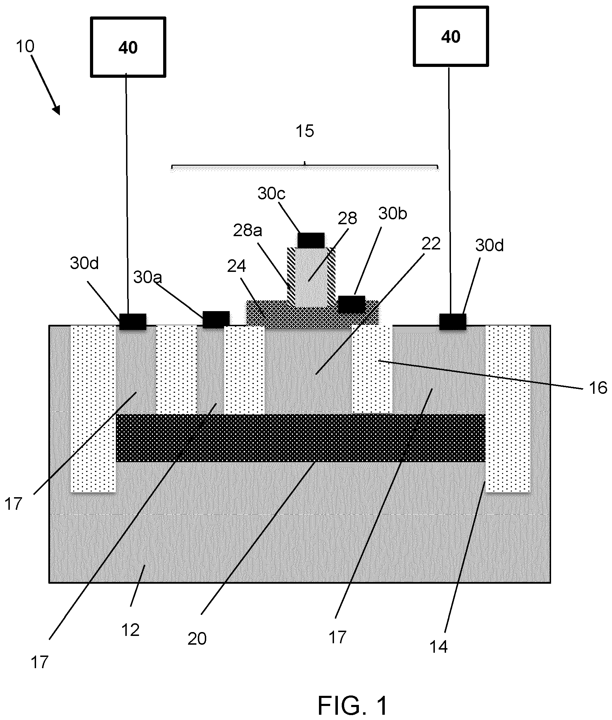

FIG. 1 shows heater terminal contacts used with a transistor, amongst other features, and respective fabrication processes in accordance with aspects of the present disclosure. More specifically, the structure 10 of FIG. 1 includes an active device 15 integrated with a semiconductor substate 12. Heating terminal contacts 30d may be provided on the semiconductor substrate 12 electrically coupled to a sub-collector region 20 of the active device 15. As described in more detail below, the heater terminal contacts 30d may be additional collector contacts 9 (via collector reach throughs 17), which can be heated upon application of a current.

The semiconductor substrate 12 may be a P-type substrate. In more specific embodiments, the semiconductor substrate 12 may be a bulk substrate comprising Si. The semiconductor substrate 12 may also be other appropriate semiconductor substrates, e.g., SiGe, SiGeC, SiC, GaAs, InAs, InP, and other III/V or II/VI compound semiconductors.

The active device 15 may be a heterojunction bipolar transistor (HBT) or another active device. For example, in an HBT, the sub-collector region 20 may be below a collector 22, e.g., n-well. In embodiments, the sub-collector region 20 may be an N+ region formed by an ion implantation process or an epitaxial growth process as is known in the art. The collector 22 may be a n-region formed by an ion implantation process or an epitaxial growth process as is known in the art. The heater terminal contacts 30d will electrically couple to the sub-collector region 20 and can generate heat upon application of a current. The device 15 further includes a collector reach throughs 17, isolated from the collector 22 by shallow trench isolation structures 16. The collector reach throughs 17 may be an n-type collector formed by an ion implantation process or an epitaxial growth process as is known in the art.

By way of example, the sub-collector region 20 and collector 22 may be formed by separate ion implantation processes or separate epitaxial growth processes with in-situ doping processes. As an example, using ion implantation processes, the sub-collector region 20 and collector 22 may be formed by introducing a concentration of a different dopant types in the semiconductor substrate 12. In embodiments, respective patterned implantation masks may be used to define selected areas exposed for the implantations. The implantation masks may include a layer of a light-sensitive material, such as an organic photoresist, applied by a spin coating process, pre-baked, exposed to light projected through a photomask, baked after exposure, and developed with a chemical developer. Each of the implantation masks has a thickness and stopping power sufficient to block masked areas against receiving a dose of the implanted ions. The collector 22 and sub-collector 20 may be doped with N-type dopants, e.g., Arsenic (As), Phosphorus (P) and Sb, among other suitable examples, with the sub-collector 20 having a higher concentration of dopant.

A base region 24 (e.g., intrinsic and extrinsic base) may be in contact with the collector region 22. The base region 24 may be SiGe material. In embodiments, the base region 24 may be T-shape or other known shape as is known in the art. The base region 24 may be formed by deposition of SiGe material, followed by conventional lithography and etching processes as described herein. The deposition process may be a conventional deposition process such as, e.g., chemical vapor deposition (CVD).

An emitter 28 may be formed in contact with the base region 24. In embodiments, the emitter 28 may be a polysilicon material with sidewall spacers 28a. The sidewall spacers 28a may be an oxide and/or nitride material. The emitter 28 and sidewall spacers 28a may be deposited by any known deposition process, e.g., CVD, followed by a patterning process as described herein. For the sidewall spacers 28a, for example, the oxide and/or nitride material may be blanket deposited over the patterned emitter 28, followed by an anisotropic etching process.

Contact 30a may be electrically coupled to the collector 22 through the collector reach through 17. Contact 30b may be electrically coupled to the base region 24, and contact 30c may be electrically coupled to the emitter 28. The contacts 30d, e.g., heater terminal contacts, may be additional contacts to the collector 22, which are electrically coupled with the sub-collector region 20. In embodiments, the heater terminal contacts 30d may be electrically isolated between the shallow trench isolation structures 16 and the deep trench isolation structure 14, to electrically couple to the sub-collector region 20. The shallow trench isolation structures 16 may also isolate contacts 30a and contacts 30b (or contacts 30b and contacts 30d).

As in each of the embodiments, a bias circuit 40 may be coupled to the heater terminal contacts 30d. The bias circuit 40 is configured to apply a voltage delta across the heater terminal contacts 30d. Current applied to the heater terminal contacts 30d results in the heater terminal contacts 30d (e.g., resistive element) generating heat to anneal or repair damage of the active device 15.

The contacts 30a, 30b, 30c, 30d may include metal material with a silicide contact formed using a silicide process. The metal material of the heater terminal contacts 30d may be a conductive material that can generate heat upon an application of current, e.g., aluminum, tungsten, copper, etc. The metal material of the contacts 30c, 30d may be deposited directly on the semiconductor substrate 12, e.g., sub-collector region 20. Contact 30b may deposited on the base region 24 and contact 30c may be deposited on the emitter 28. The contacts 30a, 30b, 30c, 30d, may be deposited using conventional CVD processes. For example, after patterning of an insulator material to form openings (e.g., vias or trenches), the contact metal can be deposited by a CVD process, followed by a chemical mechanical planarization (at different levels of the device).

Also, as should be understood by those of skill in the art, the silicide process begins with deposition of a thin transition metal layer, e.g., nickel, cobalt or titanium, over fully formed and patterned semiconductor devices (e.g., collector 22, the emitter 28 and base region 24). After deposition of the material, the structure is heated allowing the transition metal to react with exposed silicon (or other semiconductor material as described herein) in the active regions of the semiconductor device (e.g., collector 22, the emitter 28 and base region 24) forming a low-resistance transition metal silicide. Following the reaction, any remaining transition metal is removed by chemical etching, leaving silicide contacts in the active regions of the device.

In embodiments, the active device 15 may be isolated by deep trench isolation structures 14. In embodiments, the deep trench isolation structures 14 may isolate multiple active devices 15, e.g., NPNs, for a power cell application as an example. The shallow trench isolation structures 16 may provide isolation between the collector contacts 30a and the heater terminal contacts 30d. In addition, the deep trench isolation structures 14 and shallow trench isolation structures 16 will provide an isolation to the heater terminal contacts 30d.

The deep trench isolation structures 14 and shallow trench isolation structures 16 can be formed by conventional lithography, etching and deposition methods known to those of skill in the art. For example, a resist formed over the semiconductor substrate 12 is exposed to energy (light) and developed utilizing a conventional resist developer to form a pattern (opening). An etching process with a selective chemistry, e.g., reactive ion etching (RIE), will be used to transfer the pattern to form one or more trenches in the semiconductor substrate 12 through the openings of the resist. Following the resist removal by a conventional oxygen ashing process or other known stripants, an insulator material, e.g., SiO₂, can be deposited by any conventional deposition processes, e.g., chemical vapor deposition (CVD) processes. Any residual material on the surface of the semiconductor substrate 12 can be removed by conventional chemical mechanical polishing (CMP) processes.

In operation, placing a current on the heater terminal contacts 30d will generate heat from the heater terminal contacts 30d (e.g., resistive element). This heat will result in an annealing process (e.g., melt) to repair defects in the active device 15. More specifically, the heater terminal contacts 30d can generate heat, e.g., 200 °C or greater, through application of a current. In this way, it is possible to anneal radiation electrical-stress-induced defects to the oxide and semiconductor (e.g., Si) interfaces to repair or heal the damage to the active device 15. In this embodiment, any damage repair may be provided when the active device 15 is non-operational.

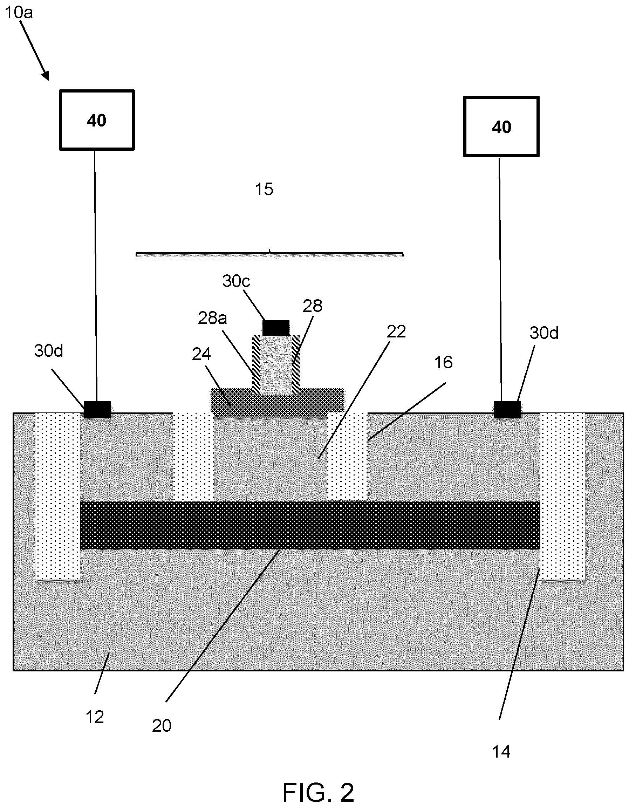

FIG. 2 shows heater terminal contacts used with a transistor, amongst other features, in accordance with additional aspects of the present disclosure. More specifically, the structure 10a of FIG. 2 includes the heater terminal contacts 30d rotated 90 degrees from the heater terminal contacts 30d of the structure 10 of FIG. 1. The remaining features of the structure 10a are similar to the structure 10 of FIG. 1.

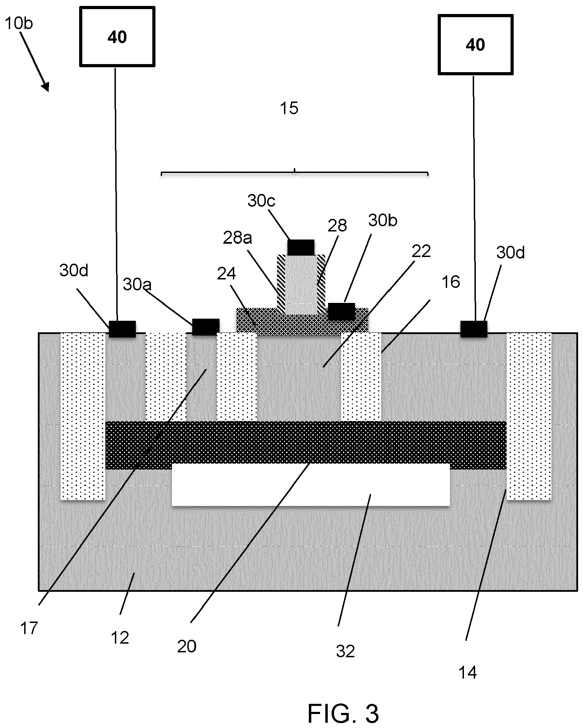

FIG. 3 shows an airgap under the sub-collector region 20 in accordance with aspects of the present disclosure. More specifically, in the structure 10b of FIG. 3, an airgap 32 is provided below the sub-collector region 20 and the heater terminal contacts 30d. In embodiments, the airgap 32 may be used to concentrate heat upwards toward the active device 15. It should be recognized by those of skill in the art that multiple airgaps are also contemplated herein. The remaining features of the structure 10b are similar to the structure 10 of FIG. 1.

The airgap 32 may be fabricated by forming a trench in the semiconductor substate 12, and filling the trench with semiconductor material different than the semiconductor substate 12. For example, the trench may be filled with SiGe material using any conventional deposition method, e.g., semiconductor epitaxial growth processes. After the formation of the heater element (and possibly other semiconductor layers) by an epitaxial growth process, the SiGe material may be removed by a selective etching process to form the airgap 32 as is known in the art.

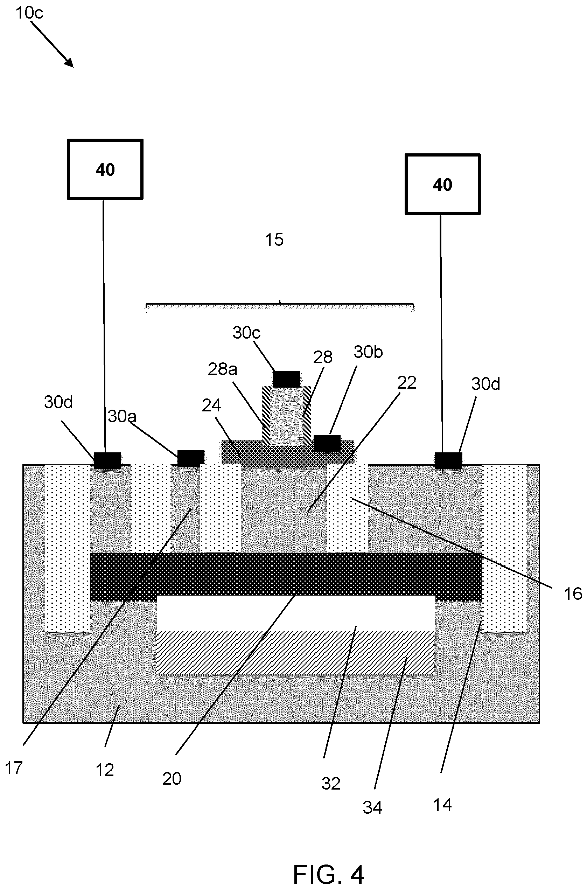

In FIG. 4, the structure 10c includes a non-single-crystal semiconductor region 34 under the airgap 32. In more specific embodiments, the non-single-crystal semiconductor region 34 may be trap rich region and, more specifically, an amorphous region or polysilicon region. In embodiments, the non-single-crystal semiconductor region 34 may reduce the effects of TID. For example, the non-single-crystal semiconductor region 34 can create traps so that the charge carriers formed as a result of ionizing radiation can recombine so that a Vt (or performance) of the device 15 does not change. The remaining features of the structure 10c are similar to the structure 10b of FIG. 3.

The non-single-crystal semiconductor region 34 may be formed by an implantation process, using a patterned implantation mask. For example, the non-single-crystal semiconductor region 34 may be formed by a blanket argon implant process using argon; although the use of any non-dopant or noble gas is contemplated herein for the implantation process. As an illustrative, non-limiting example, the semiconductor substrate 12 can be subjected to an argon implant at 300 KeV and a dose of 1×10¹⁵ cm⁻². By way of further illustrative examples, other implant parameters and inert gases are contemplated herein depending on the desired thickness and depth of the implant region including, e.g., the ion dose may be less than or greater than 1×10¹⁵ cm⁻² or within a range of 1×10¹³ cm⁻² to 5×10¹⁶ cm⁻².

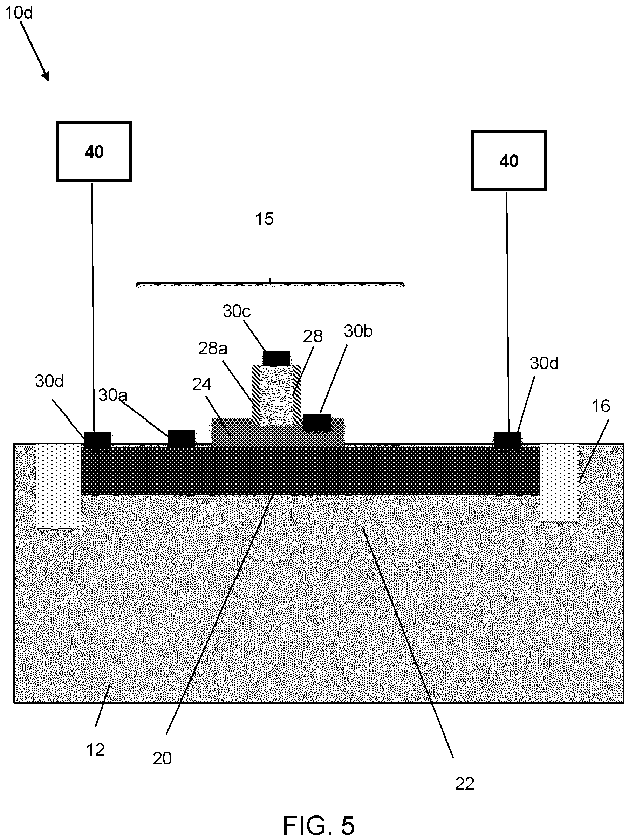

In FIG. 5, the structure 10d includes the sub-collector region 20 extending to the upper surface of the semiconductor substrate 12 and between shallow trench isolation structures 16. In this embodiment, the heater terminal contacts 30d and collector contacts 30a are coupled to the sub-collector region 20. Also, in this embodiment, there is no insulator material, e.g., shallow trench isolation structures, between the heater terminal contacts 30d and collector contacts 30a. The remaining features of the structure 10d are similar to the structure 10 of FIG. 1.

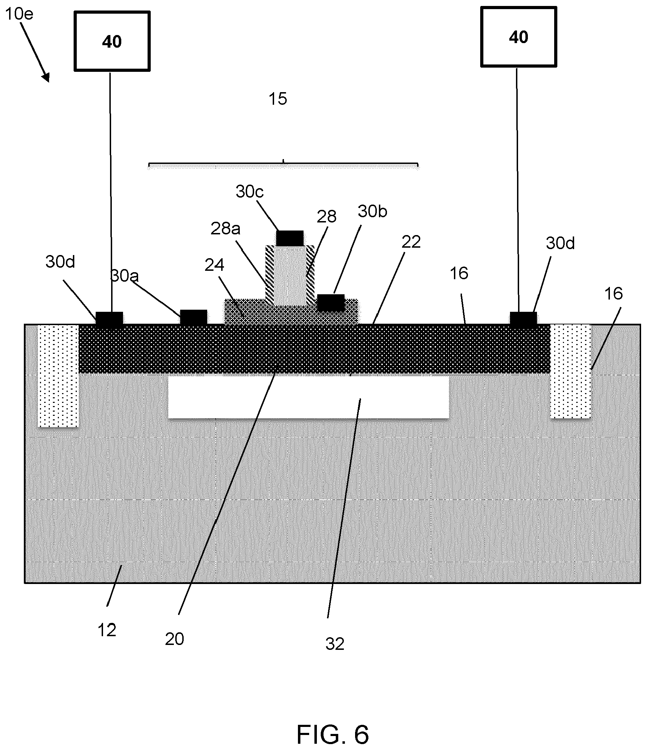

In the structure 10e of FIG. 6, an airgap 32 is under the sub-collector region 20 in accordance with aspects of the present disclosure. The remaining features of the structure 10e are similar to the structure 10d of FIG. 5.

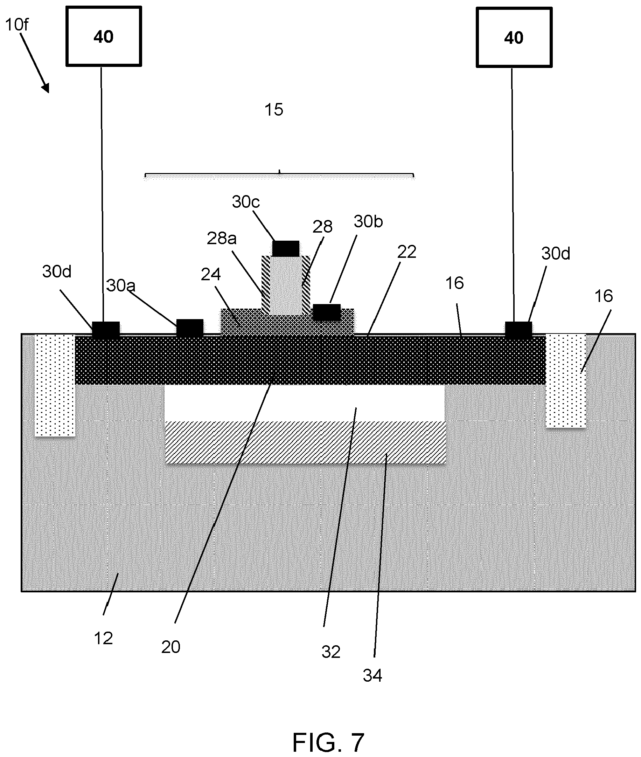

In the structure 10f of FIG. 7, the non-single-crystal semiconductor region 34 may be formed under the airgap 32. The remaining features of the structure 10f are similar to the structure 10e of FIG. 6.

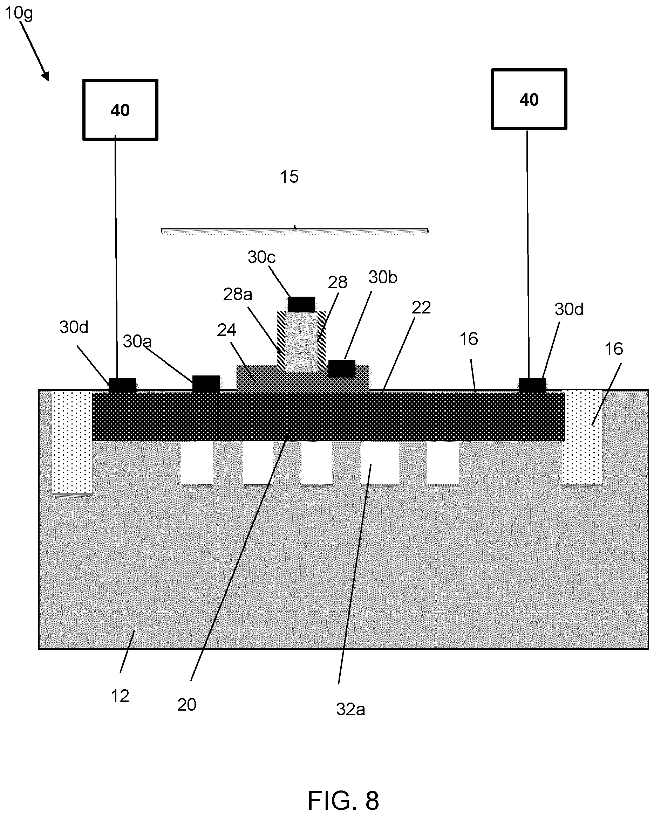

In the structure 10g of FIG. 8, multiple airgaps 32a are formed under the sub-collector region 20. The remaining features of the structure 10g are similar to the structure 10e of FIG. 6.

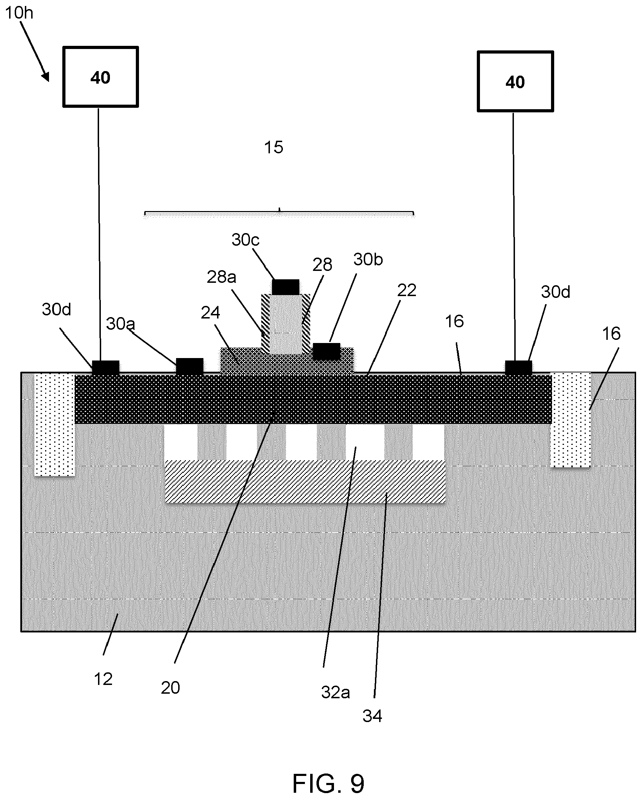

In the structure 10h of FIG. 9, the non-single-crystal semiconductor region 34 may be formed under the multiple airgaps 32a under the sub-collector region 20. The remaining features of the structure 10h are similar to the structure 10g of FIG. 8. It should also be recognized by those of skill in the art that the structures of FIGS. 2-9 may include any combination of the one or more airgaps and/or non-single-crystal semiconductor region and/or sub-collector region at or below a surface of the semiconductor substrate 12.

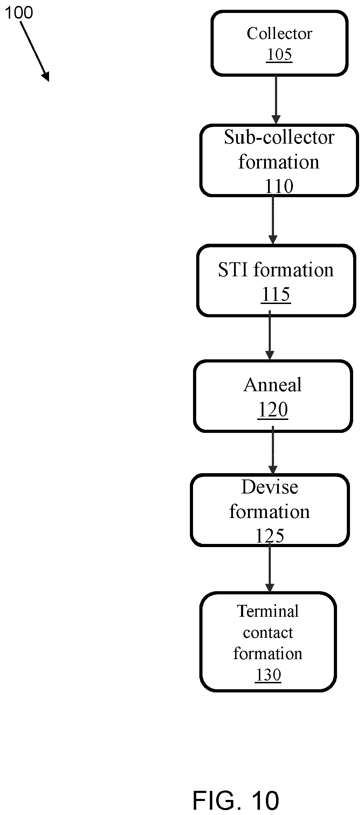

FIG. 10 shows a representative flow 100 of a fabrication process for manufacturing the structure 10 of FIG. 1. Similar fabrication processes may be used for the structures shown in FIGS. 2-9.

At step 105, an ion implantation process with a P+ type dopant may be performed on the semiconductor layer 12 to form the collector 22. At step 110, an ion implantation process with an N-type dopant may be performed on the semiconductor layer 12 to form the collector 22. At step 115, the shallow trench isolation structures 16 and/or deep trench isolation structures 14 may be formed by conventional lithography, etching and deposition processes as described above. At step 120, an anneal process may be performed to drive in the dopants of the previous implant processes as is known in the art. At step 125, the device 15 may be formed using conventional CMOS processes such that no further explanation is required for a complete understanding of the present disclosure. At step 130, the terminal contacts 30a, 30b, 30c, 30d may be formed using conventional CMOS processes such that no further explanation is required for a complete understanding of the present disclosure.

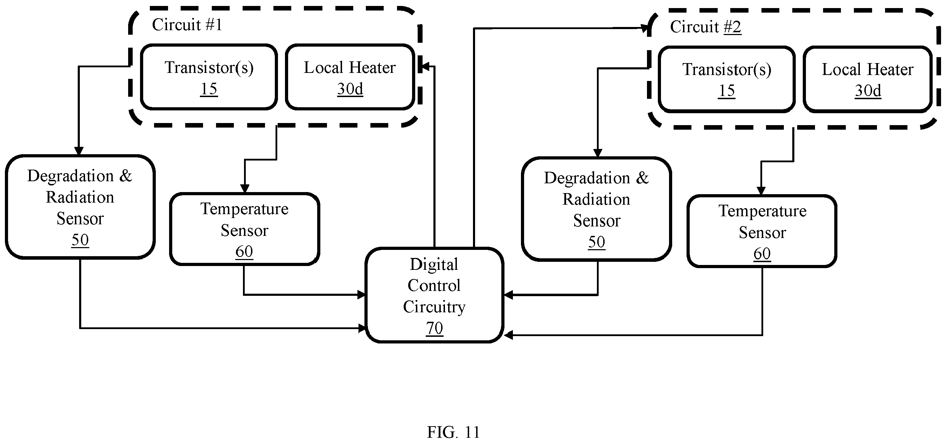

FIG. 11 shows a representative flow of an operation of the structures shown in FIGS. 1-9, with additional operational components in accordance with aspects of the present disclosure. More specifically, the flow includes redundant circuit, e.g., circuit #1 and circuit #2, each of which include the active device 15 and the heater terminal contacts 30d (e.g., heater elements). The circuits further include a degradation and radiation sensor 50, temperature sensor 60 and digital control circuitry 70. In embodiments, while one circuit block is healing, the control circuit can use a redundant circuit to maintain the electrical functionality of the system.

In operation, the degradation and radiation sensor 50 will sense the radiation, e.g., TID, and degradation of the device 15. For example, the degradation and radiation sensor 50 may sense a change in circuit performance due to radiation damage. The information from the degradation and radiation sensor 50 is fed into a digital control circuit 70 that governs whether a device should be heated to anneal defects in the device. While the device 15 is being heated for repair, its temperature is sensed using a separate temperature sensor 60. The temperature is maintained in a negative feedback loop through the digital control circuit 70 to ensure that the device is not overheated, hence, not impaired by the heating process.

The heater terminal contacts can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure (10) comprising:
a heterojunction bipolar transistor (15) comprising a collector (22), sub-collector region (20), emitter (28) and base region (24); and
heater terminal contacts (30d) electrically coupled to the sub-collector region (20).

2. The structure (10) of claim 1, wherein the heater terminal contacts (30d) are orthogonally positioned relative to a contact (30a) to the collector (22).

3. The structure (10) of claim 1 or 2, wherein the heater terminal contacts (30d) comprise metal structures on a surface of a semiconductor substrate (12).

4. The structure (10) of claim 1 or 2, wherein the sub-collector region (20) extends at least partially to a surface of the semiconductor substrate (12) and the heater terminal contacts (30d) and a contact (30a) to the collector (22) are on the sub-collector region (20).

5. The structure (10) of one of claims 1 to 4, wherein the heater terminal contacts (30d) are electrically isolated by a deep trench isolation structure (14) and a shallow trench isolation structure (16), or wherein the heater terminal contacts (30d) and a contact (30a) to the collector (22) are not electrically isolated.

6. The structure (10) of one of claims 1 to 5, further comprising at least one airgap (32, 32a) below the sub-collector region (20).

7. The structure (10) of claim 6, further comprising a non-single crystal semiconductor region (34) below the at least one airgap (32, 32a).

8. The structure (10) of one of claims 1 to 7, further comprising redundant circuitry coupled to a common control circuit, wherein each of the redundant circuitry comprises a performance sensor (50) and a temperature sensor (60) coupled to the common control circuit, the performance sensor (50) detects a change in circuit performance of the heterojunction bipolar transistor (15), the common control circuit receives the circuit performance from the performance sensor (50) and governs whether the heat should be applied to anneal defects, and the temperature sensor (60) detects the heat.

9. A structure (10) comprising:
a heterojunction bipolar transistor (15) integrated with a semiconductor substrate (12);
heater terminal contacts (30d) electrically coupled to a sub-collector region (20) of the heterojunction bipolar transistor (15);
a collector contact (30a) to the heterojunction bipolar transistor (15);
a base region contact (30b) to the heterojunction bipolar transistor (15); and
an emitter contact (30c) to the heterojunction bipolar transistor (15).

10. The structure (10) of claim 9, further comprising a shallow trench isolation structure (16) between the heater terminal contacts (30d) and the collector contact (30a).

11. The structure (10) of claim 9 or 10, wherein the sub-collector region (20) extends at least partially to a top surface of the semiconductor substrate (12), and the heater terminal contacts (30d) and the collector contact (30a) are provided on a surface of the sub-collector region (20).

12. The structure (10) of one of claims 9 to 11, further comprising at least one airgap (32, 32a) below the sub-collector region (20).

13. The structure (10) of claim 12, further comprising a non-single crystal semiconductor region (34) below the at least one airgap (32, 32a).

14. The structure (10) of one of claims 9 to 13, wherein the heater terminal contacts (30d) are electrically isolated by a deep trench isolation structure (14) and the shallow trench isolation structure (16).

15. A structure (10) comprising:
a first structure comprising:
a first active device; and
a first set of heater terminal contacts (30d) electrically coupled to a component of the first active device;
a second structure comprising:
a second active device; and
a second set of heater terminal contacts (30d) electrically coupled to a component of the second active device; and
a redundant circuitry coupled to the first structure and the second structure, the redundant circuitry comprising:
a first circuit with a first performance sensor (50) configured to detect a change in performance of the first active device and a temperature sensor (60) configured to detect heat generated from the first set of heater terminal contacts (30d); and
a second circuit with a performance sensor (50) configured to detect a change in performance of the second active device and a temperature sensor (60) configured to detect heat generated from the second set of heater terminal contacts (30d), wherein
the redundant circuitry controls a current to the first set of heater terminal contacts (30d) while maintaining electrical functionality of the second active device and non- electrical functionality to the first active device, and
the redundant circuitry controls a current to the second set of heater terminal contacts (30d) while maintaining electrical functionality of the first active device and non- electrical functionality to the second active device.
